# EUROPEAN PATENT SPECIFICATION

(11) **EP 4 352 784 B1**
(45) Date of publication and mention of the grant of the patent: **19.11.2025**
(21) Application number: 22820721.3
(22) Date of filing: 09.03.2022
(51) Int. Cl.: H01L 23/538, H01L 23/00, H01L 25/04, H01L 23/48, H01L 23/528, H01L 23/13, H01L 23/498, H01L 25/065

(54) **PACKAGE WITH EMBEDDED DEVICE CAVITY PROVIDED BY SPACED INTERPOSERS**
VERPACKUNG MIT EINGEBETTETEM VORRICHTUNGSHOHLRAUM, DER DURCH BEABSTANDETEN INTERPOSERN BEREITGESTELLT WIRD
EMBALLAGE AVEC CAVITÉ DE DISPOSITIF INTÉGRÉE FOURNIE PAR DES INTERPOSEURS ESPACÉS

(30) Priority: 11.06.2021 US 202117345925
(43) Date of publication of application: 17.04.2024
(73) Proprietor: INTEL Corporation, Santa Clara, CA 95054 (US)
(72) Inventor: MARIN, Brandon C., Gilbert, Arizona 85234 (US)
(74) Representative: Goddar, Heinz J.
(86) International application number: PCT/US2022/019493
(87) International publication number: WO 2022/260733

(56) References cited:
- WO-A1-2017/120272
- US-A1- 2013 161 836
- US-A1- 2014 029 639
- US-A1- 2015 255 434
- US-A1- 2015 255 434
- US-A1- 2016 133 600
- US-A1- 2017 133 323
- US-A1- 2020 128 669
- US-A1- 2020 144 170

## Description

### TECHNICAL FIELD

Embodiments of the present description generally relate to the field of integrated circuit package fabrication, and, more specifically, to an integrated circuit assembly including embedded devices.

### BACKGROUND

The integrated circuit industry is continually striving to produce ever faster, smaller, and thinner integrated circuit packages for use in various electronic products, including, but not limited to, computer servers and portable products, such as portable computers, electronic tablets, cellular phones, digital cameras, and the like.

As a part of this effort, integrated circuit packages containing multiple integrated circuit devices, such as microelectronic dice, have been developed. These multiple integrated circuit device packages are referred to in the art as multi-device, multi-chip packages (MCPs), or partitioned devices, and offer the potential for increased architectural flexibility at reduced cost, but must do so such that appropriate integrated circuit device-to-integrated circuit device interconnect densities are provided. As will be understood to those skilled in the art, interconnect density is an important consideration because an insufficient number of integrated circuit device connections would limit the bandwidth capability for the affected integrated circuit device interface, and thus would reduce the communication efficiency and capability between integrated circuit devices.

To address interconnection concerns, a bridge may be embedded in a substrate to which the integrated circuit devices are attached. These bridges support dense integrated circuit device-to-integrated circuit device interconnects, such as from a first integrated circuit device edge to a second integrated circuit device edge, and may support a number of signal lines through the bridge itself. Instead of using an expensive silicon interposer with through silicon vias, the bridge may be an inactive silicon patch or an active silicon device that is embedded in the substrate, enabling the dense integrated circuit device-to-integrated circuit device interconnects only where needed. Standard flip-chip processes may be used to connect the integrated circuit devices to the substrate for robust power delivery and to the bridge within the substrate. Thus, a resulting integrated circuit package may be considerably smaller than an integrated circuit package that is only interconnected with conductive routes within the substrate. US 2020/144170 A1 discloses an electronic package comprising a substrate, standoff substrate(s) and electronic components located within a clearance and/or one or more cavities. The substrate comprises substrate via(s) and/or substrate redistribution layer(s) and/or one or more cavities and/or substrate through hole(s). The standoff substrate(s) is coupled to said substrate. The standoff substrate(s) forms a clearance on the top and/or bottom surface of said substrate. The standoff substrate(s) comprises standoff substrate via(s) and/or standoff substrate Redistribution layer(s). The standoff substrate via(s) and/or said standoff substrate Redistribution layer(s) are coupled to said Redistribution layer(s) and/or said substrate via(s). The electronic component is coupled to said substrate and/or said at least one standoff substrate. The electronic components including a first electronic component and a second electronic component. The first electronic component is the same electronic component as compared to the second electronic component. The invention is set forth in the independent claims. Embodiments of the invention are described in the dependent claims.

### BRIEF DESCRIPTION OF THE DRAWINGS

The subject matter of the present disclosure is particularly pointed out and distinctly claimed in the concluding portion of the specification. The foregoing and other features of the present disclosure will become more fully apparent from the following description and appended claims, taken in conjunction with the accompanying drawings. It is understood that the accompanying drawings depict only several embodiments in accordance with the present disclosure and are, therefore, not to be considered limiting of its scope. The disclosure will be described with additional specificity and detail through use of the accompanying drawings, such that the advantages of the present disclosure can be more readily ascertained, in which:
FIGs. 1-3 are perspective views of an integrated circuit package, according to one embodiment of the present description.
FIG. 4 ia a perspective view of an integrated circuit package, according to one embodiment of the present description.
FIG. 5 is a top view of an integrated circuit package, according to one embodiment of the present description.
FIG. 6 is a block diagram of an electronic system, according to one embodiment of the present description.
FIGs. 7 and 8 are illustrative diagrams of respective arrangements of patches and components, according to embodiments of the present description.
FIGs. 9-14 are top views and side cross-sectional views of a process for fabrication of an integrated circuit package, according to an embodiment of the present description.
FIG. 15 is an electronic system, according to one embodiment of the present description.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter. It is to be understood that the various embodiments, although different, are not necessarily mutually exclusive. For example, a particular feature, patch, or characteristic described herein, in connection with one embodiment, may be implemented within other embodiments without departing from the spirit and scope of the claimed subject matter. References within this specification to "one embodiment" or "an embodiment" mean that a particular feature, patch, or characteristic described in connection with the embodiment is included in at least one implementation encompassed within the present description. Therefore, the use of the phrase "one embodiment" or "in an embodiment" does not necessarily refer to the same embodiment. In addition, it is to be understood that the location or arrangement of individual elements within each disclosed embodiment may be modified without departing from the spirit and scope of the claimed subject matter. The following detailed description is, therefore, not to be taken in a limiting sense, and the scope of the subject matter is defined only by the appended claims, appropriately interpreted, along with the full range of equivalents to which the appended claims are entitled. In the drawings, like numerals refer to the same or similar elements or functionality throughout the several views, and that elements depicted therein are not necessarily to scale with one another, rather individual elements may be enlarged or reduced in order to more easily comprehend the elements in the context of the present description.

The terms "over", "to", "between" and "on" as used herein may refer to a relative position of one layer with respect to other layers. One layer "over" or "on" another layer or bonded "to" another layer may be directly in contact with the other layer or may have one or more intervening layers. One layer "between" layers may be directly in contact with the layers or may have one or more intervening layers.

The term "package" generally refers to a self-contained carrier of one or more dice, where the dice are attached to the package substrate, and may be encapsulated for protection, with integrated or wire-boned interconnects between the dice and leads, pins or bumps located on the external portions of the package substrate. The package may contain a single die, or multiple dice, providing a specific function. The package is usually mounted on a printed circuit board for interconnection with other packaged integrated circuits and discrete components, forming a larger circuit.

Here, the term "cored" generally refers to a substrate of an integrated circuit package built upon a board, card or wafer comprising a non-flexible stiff material. Typically, a small printed circuit board is used as a core, upon which integrated circuit device and discrete passive components may be soldered. Typically, the core has vias extending from one side to the other, allowing circuitry on one side of the core to be coupled directly to circuitry on the opposite side of the core. The core may also serve as a platform for building up layers of conductors and dielectric materials.

Here, the term "coreless" generally refers to a substrate of an integrated circuit package having no core. The lack of a core allows for higher-density package architectures, as the through-vias have relatively large dimensions and pitch compared to high-density interconnects.

Here, the term "land side", if used herein, generally refers to the side of the substrate of the integrated circuit package closest to the plane of attachment to a printed circuit board, motherboard, or other package. This is in contrast to the term "die side", which is the side of the substrate of the integrated circuit package to which the die or dice are attached.

Here, the term "dielectric" generally refers to any number of non-electrically conductive materials that make up the patch of a package substrate. For purposes of this disclosure, dielectric material may be incorporated into an integrated circuit package as layers of laminate film or as a resin molded over integrated circuit dice mounted on the substrate.

Here, the term "metallization" generally refers to metal layers formed over and through the dielectric material of the package substrate. The metal layers are generally patterned to form metal patches such as traces and bond pads. The metallization of a package substrate may be confined to a single layer or in multiple layers separated by layers of dielectric.

Here, the term "bond pad" generally refers to metallization patches that terminate integrated traces and vias in integrated circuit packages and dies. The term "solder pad" may be occasionally substituted for "bond pad" and carries the same meaning.

Here, the term "solder bump" generally refers to a solder layer formed on a bond pad. The solder layer typically has a round shape, hence the term "solder bump".

Here, the term "substrate" generally refers to a planar platform comprising dielectric and metallization patches. The substrate mechanically supports and electrically couples one or more IC dies on a single platform, with encapsulation of the one or more IC dies by a moldable dielectric material. The substrate generally comprises solder bumps as bonding interconnects on both sides. One side of the substrate, generally referred to as the "die side", comprises solder bumps for chip or die bonding. The opposite side of the substrate, generally referred to as the "land side", comprises solder bumps for bonding the package to a printed circuit board.

Here, the term "assembly" generally refers to a grouping of parts into a single functional unit. The parts may be separate and are mechanically assembled into a functional unit, where the parts may be removable. In another instance, the parts may be permanently bonded together. In some instances, the parts are integrated together.

Throughout the specification, and in the claims, the term "connected" means a direct connection, such as electrical, mechanical, or magnetic connection between the things that are connected, without any intermediary devices.

The term "coupled" means a direct or indirect connection, such as a direct electrical, mechanical, magnetic or fluidic connection between the things that are connected or an indirect connection, through one or more passive or active intermediary devices.

The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The vertical orientation is in the z-direction and it is understood that recitations of "top", "bottom", "above" and "below" refer to relative positions in the z-dimension with the usual meaning. However, it is understood that embodiments are not necessarily limited to the orientations or configurations illustrated in the figure.

The terms "substantially," "close," "approximately," "near," and "about," generally refer to being within +/- 10% of a target value (unless specifically specified). Unless otherwise specified the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional", "profile" and "plan" correspond to orthogonal planes within a cartesian coordinate system. Thus, cross-sectional and profile views are taken in the x-z plane, and plan views are taken in the x-y plane. Typically, profile views in the x-z plane are cross-sectional views. Where appropriate, drawings are labeled with axes to indicate the orientation of the figure.

As a computing device becomes more complex or includes more performance or capacity, more components may be integrated in a package, which may lead to an increase in build-up (BU) area and die area usage. A problem is that package cost may increase proportional to BU area usage. Package cost may further increase based on yield loss (YL), which increases with added layer count (LC). Some embodiments may overcome one or more of the foregoing problems with patches that include protrusions that may be configured to provide cavities for embedded devices. For example, a patch may refer to an interposer that may be configured as a substrate structure, a bridge, or simply as a support for other devices, substrates, or layers of a package. Advantageously, some embodiments provide one or more of X, Y, and/or Z disaggregation (e.g., relative to X, Y, Z coordinates) to separate YL prone technologies (e.g., such as embedded multi-die interconnect bridges (EMIBs)) into patch configurations that may reduce overall BU usage and/or isolate YL to smaller LC patches.

Some embodiments may utilize inter-fitted patches with a variety of shapes (e.g., square shapes, rectangular shapes, non-rectangular shapes, irregular shapes, asymmetric shapes, shapes with arms, legs, or other protrusions, etc.) to accommodate an open cavity for an embedded component (e.g., an EMIB, a photonics device, etc.). In some embodiments, gaps may be left between various of the patches. In some embodiments, signal cables may be routed through the gaps to embedded components in the cavities.

Embodiments of patches may be shaped in any useful manner that provide one or more open cavities for component integration and X-Y and/or Z-disaggregation of the package. Advantageously, Z-disaggregation may lower overall package costs and/or provide a device with better performance at a lower cost. Some embodiments may also segment YL (e.g., with more disaggregation, YL may affect fewer components, lower cost sub-package assemblies, lower LC substrates, etc.). Embodiments may provide integrated circuit (IC) packages for photonics ICs (PICs) and/or V-groove technologies. Embodiments may also support one or more EMIB devices with through-silicon vias (TSVs) (e.g., which may be better for power delivery).

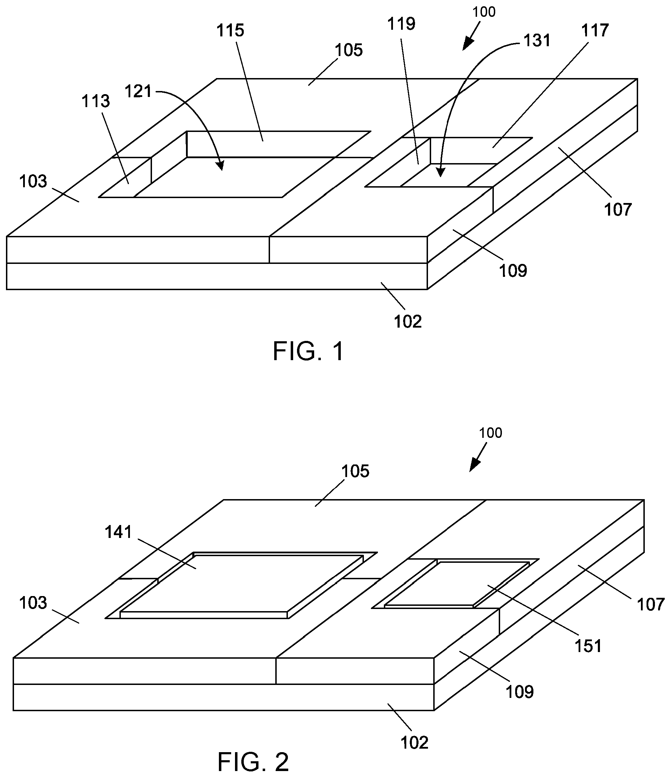

With reference to FIG. 1, an embodiment of an IC package 100 comprises a substrate stack that may include a primary interposer 102 (e.g., comprising a laminate and one or more metal vias through the laminate) and two or more secondary interposers 103, 105, 107, and 109 attached to a first side of the primary interposer 102. As shown in FIG. 1, sidewalls 113, 115, 117, and 119 of the secondary interposers 103, 105, 107, and 109 define one or more recesses 121 and 131 over the primary interposer 102.

FIG. 2 shows an embodiment where the IC package 100 further includes an embedded component 141 within the recess 121 defined by the respective sidewalls of secondary interposers 103 and 105, and an embedded component 151 within the recess 131 defined by the respective sidewalls of secondary interposers 107 and 109.

Any suitable materials may be utilized for the interposers 102, 103, 105, 107, and 109 and any known process may be utilized to fabricate the same. By making the primary interposer and the secondary interposers as separate pieces, embodiments advantageously support both X-Y disaggregation and Z-disaggregation of the fabrication process. In some embodiments, the secondary interposers may be fabricated by a substrate stack-up or build-up process where at least a first interposer 103 of the two or more secondary interposers comprises a dielectric material with metallization features embedded in the dielectric material, and at least a second interposer 105 of the two or more secondary interposers also comprises a dielectric material with metallization features embedded in the dielectric material. For example, the first and second interposers 103, 105 may provide a package substrate, a bridge, or the like.

To support disaggregation, the recess 121 is not formed directly on the primary interposer 102 (e.g., as build-up layers, a substrate stack-up with a cavity drilled therethrough, etc.), or in a single substrate structure. Instead, recesses are provided by inter-fitting two or more pieces to support disaggregation. For example, at least a first sidewall of the dielectric material of one interposer (e.g., the sidewall 113 of the interposer 103) and at least a first sidewall of the dielectric material of another interposer (e.g., sidewall 115 of the interposer 105) inter-fit to define portions of the recess 121 (e.g., in this example, all of the interior sidewalls of the interposers 103 and 105 define the recess 121).

In some embodiments, all or some of the secondary interposers may have regular shapes, such as square shapes, rectangular shapes, etc. On the other hand, as shown in FIGs 1 and 2, the secondary interposers may include a main body portion (e.g., defined by the largest regular shape of the interposer), and one or more protrusions that give the interposer are more irregular shape. The protrusions may be referred to as arms, legs, diving boards, etc. and may be selected to abut or be placed near to the main bodies and/or protrusions of other secondary interposers to define recesses over the primary interposer. Although not limited to recognizable shapes or patterns, in some embodiments, the secondary interposers may have shapes generally recognized as a C-shape, an E-shape, an F-shape, an H-shape, an I-shape, an S-shape, a T-shape, etc.

In some embodiments, one or more of the embedded components may comprise a bridge attached to the primary interposer and coupled to one or more of the first metallization features of the first interposer and the second metallization features of the second interposer. For example, the primary interposer 102 may comprise an organic interposer such as a stacked via laminate core (SVLC), the bridge may comprise an embedded multi-die interconnect bridge (EMIB), the first interposer 103 may comprise a first coreless patch, and the second interposer 105 may comprise a second coreless patch.

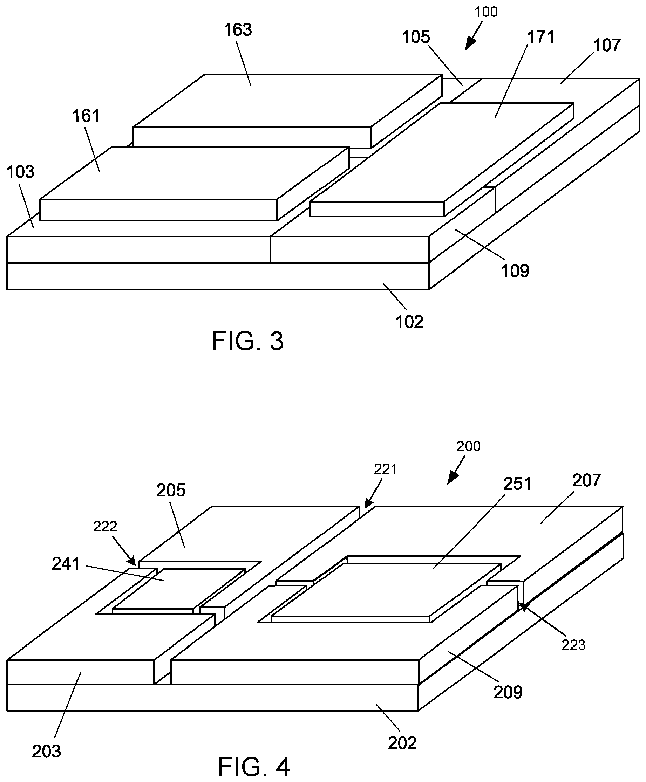

FIG. 3 shows an embodiment where the IC package 100 may further include one or more IC devices coupled to the embedded components. For example, the metallization features of the first interposer 103 may comprise first interfaces to couple with an IC die through first-level interconnect features, and a first IC chip 161 may comprise first terminals coupled to the interfaces of the first interposer 103, and second terminals coupled to first terminals of the embedded component 141. In some embodiments, the metallization features of the second interposer 105 may also comprise interfaces to couple with an IC die through first-level interconnect features, and a second IC chip 163 may comprise first terminals coupled to the interfaces of the second interposer, and second terminals coupled to second terminals of the embedded component. Another IC chip 171 may be coupled to the embedded component 151 and both secondary interposers 107 and 109.

With reference to FIG. 4, an embodiment of an IC package 200 may be similar to the IC package 100, including a substrate stack with a primary interposer 202 (e.g., a SVLC), two or more secondary interposers 203, 205, 207, and 209 attached to a first side of the primary interposer 202 (e.g., where sidewalls of the secondary interposers 203, 205, 207, and 209 define one or more recesses over the primary interposer 202, an embedded component 241 within the recess defined by the respective sidewalls of the secondary interposers 203 and 205, and an embedded component 251 within the recess defined by the respective sidewalls of secondary interposers 207 and 209. The secondary interposers have non-rectangular shapes (e.g., an L-shape for interposers 203 and 205, and a C-shape or U-shape for interposers 207 and 209) that include various protrusions extended from the respective main bodies of the secondary interposers. As shown in FIG. 4, the IC package 200 may include further recesses defined by sidewalls of the secondary interposers that provide one or more gaps 221, 222, and 223 between the secondary interposers.

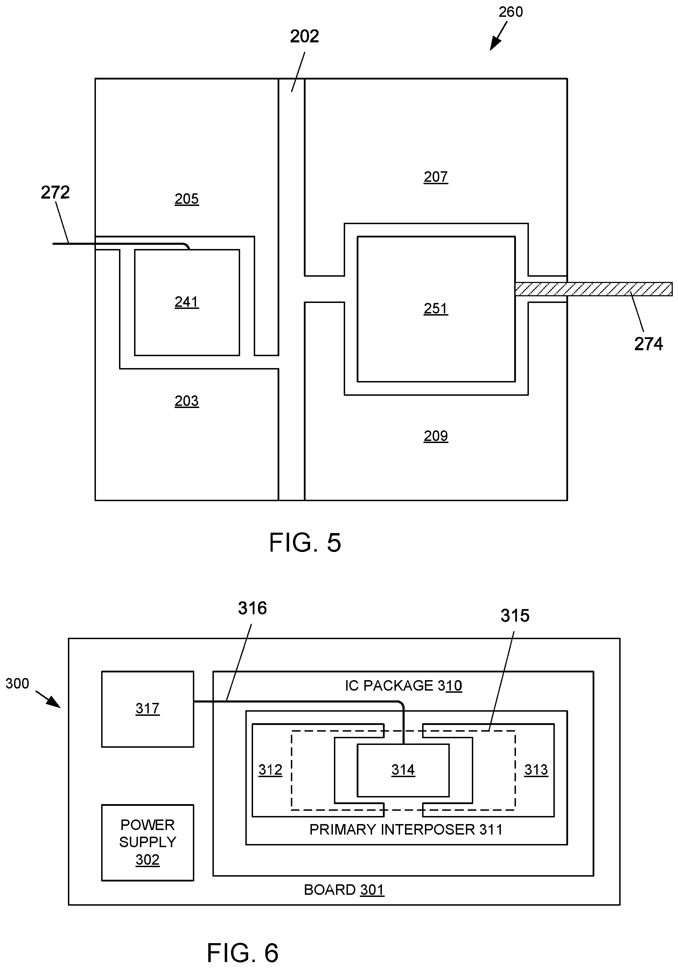

With reference to FIG. 5, an embodiment of an IC package 260 may be similar to the IC package 200, with similar items indicated by like numerals. The IC package 260 includes one or more signal cables within one or more recesses defined by the respective sidewalls of the two or more secondary interposers that provide gaps between the secondary interposers, where the signal cable(s) is/are attached to the embedded components. As shown in FIG. 5, a signal cable 272 may be routed within a gap between the secondary interposers 203, 205 and coupled to the embedded component 241. In one embodiment of the present description, the embedded component 251 may comprise a photonics IC chip attached to the primary interposer 202, and a signal cable 274 comprising a fiber optic cable may be routed within a gap between the secondary interposers 207, 209 and coupled to the photonics IC chip. The IC package 260 may further include one or more additional IC chips attached to the secondary interposers and embedded components 241, 251 (e.g., all of which may be coupled to each other through suitable metallization features, interfaces, and various interconnect levels).

With reference to FIG. 6, an embodiment of an electronic system 300 may comprise a board 301, a power supply 302 to provide power to one or more IC chips, and an IC package 310 attached to the board 301 and coupled to the power supply 302. The IC package 310 may comprises a primary interposer 311 (e.g., a SVLC), at least two secondary interposers 312 and 313 attached to a first side of the primary interposer 311, where respective sidewalls of the interposers 312, 313 define a first recess over the primary interposer 311. For example, the interposers 312, 313 may comprise coreless substrate patches with metallization features embedded in dielectric material. The IC package 310 further includes an embedded component 314 within the first recess, and an IC chip 315 coupled to one or more of the interposers 312, 313 and the embedded component 314 (e.g., through suitable metallization features, interfaces, and various interconnect levels).

The system 300 further includes a signal cable 316 connected between another IC chip 317 on the board 301 and the embedded component 314. For example, the embedded component 314 may comprise a photonics IC chip with V-groove attachment technology and the signal cable 316 may comprise a fiber optic cable within a second recess defined by the respective sidewalls of the two interposers 312, 313 (e.g., routed through a gap provided between the interposers 312, 313) and physically attached to the V-groove of the photonics IC chip.

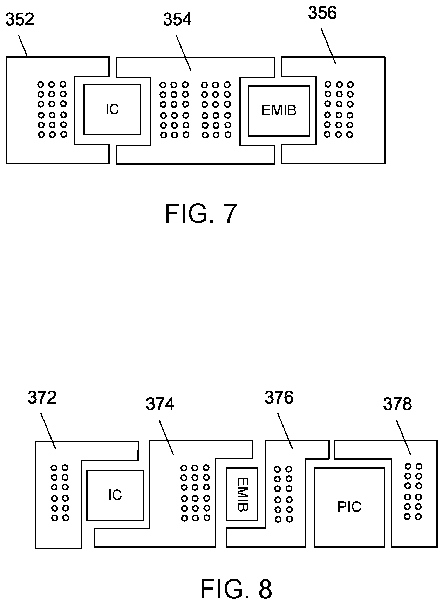

With reference to FIGs. 7 and 8, other examples of interposer patches 352, 354, 356, 372, 374, 376, and 378 show how the patches may have any of various shapes (e.g., a general H or I shape for the patch 354, a general S-shape for the patches 374 and 376), and how an IC package may utilize any of a number and variety of patches, ICs, bridges, etc. as needed for a particular device.

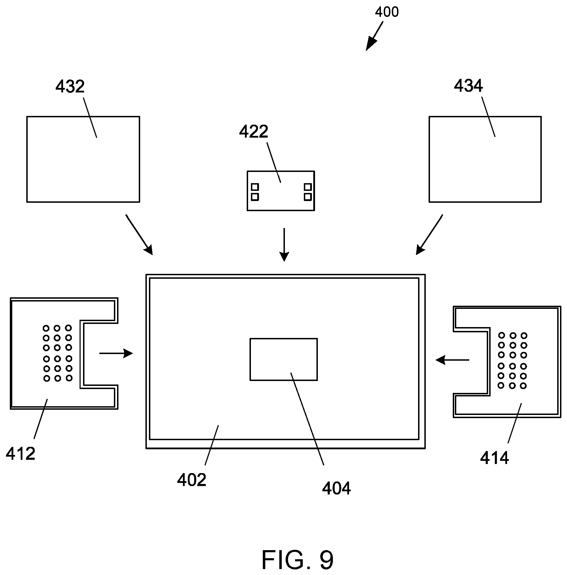

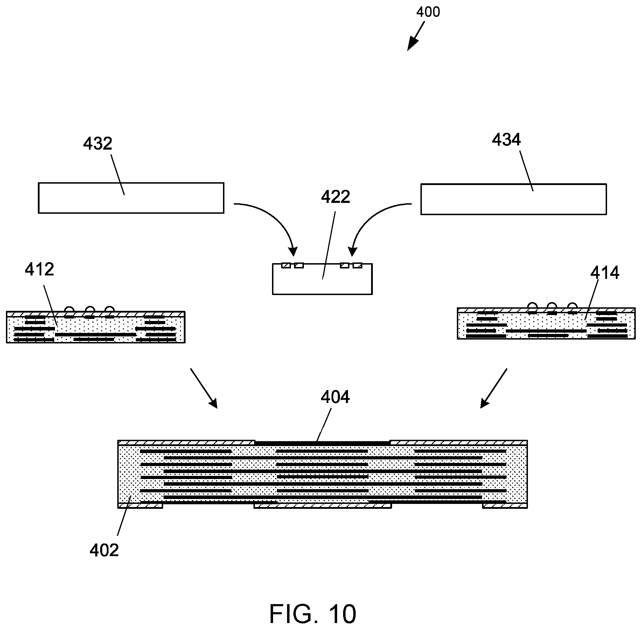

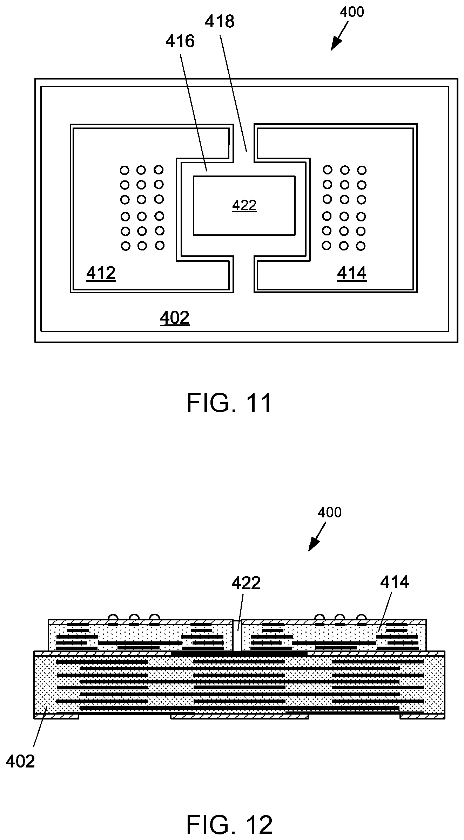

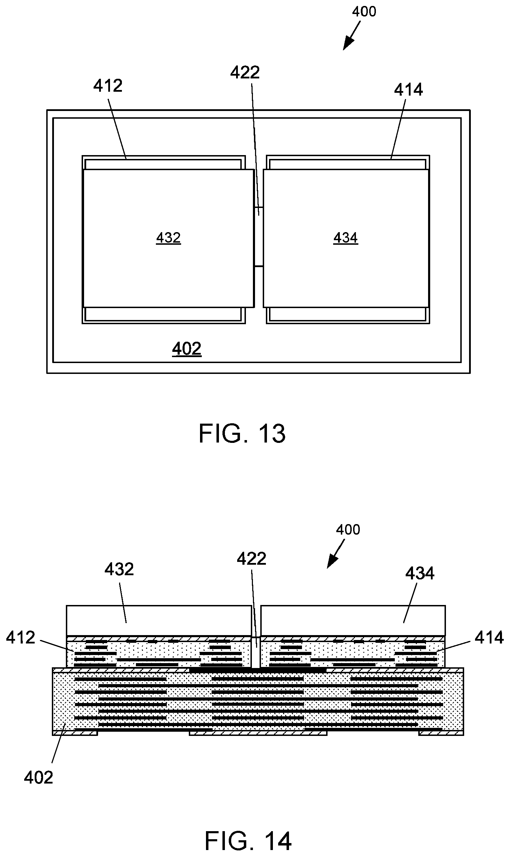

FIGs. 9-14 illustrate one embodiment of the fabrication of an IC package 400 that utilizes a shadow diving board (e.g., an inverted diving board, or a general C or U-shape) for X-Y and Z-disaggregation and an open cavity EMIB. In this example, the IC package 400 includes a SVLC 402 with a mount area 404 for an embedded component (e.g., an exposed copper area), a first coreless C-patch 412, a second coreless C-patch 414, an EMIB 422, and two ICs 432 and 434. FIG. 9 shows how the fabrication of the IC package 400 has X-Y disaggregation. FIG. 10 shows how the fabrication of the IC package 400 has Z-disaggregation. FIGs. 11 and 12 show the two coreless C-patches 412 and 414 attached to the SVLC, with sidewalls of the coreless C-patches 412 and 414 defining a first recess 416 for the EMIB 422. The EMIB 422 is attached to the SVLC 402 within the first recess 416. Other sidewalls of the two coreless C-patches define additional recesses that provide gaps between the C-patches 412 and 414 (e.g., in some embodiments signal cables may be routed within the gaps). FIGs. 13 and 14 show the two ICs 432 and 434 attached to the EMIB 422 and respectively attached to the two coreless C-patches 412 and 414.

Any suitable material and any known process may be utilized to attached the IC chips 432, 434 to first level interconnects of the C-patches 412, 414 and/or the EMIB 422. In one embodiment of the present description, a plurality of substrate-to-board bond pads may be formed on a dielectric layer and electrically attached to respective conductive vias. External interconnects, such as solder, may be attached to the substrate-to-board pond pads. The external interconnects may be used to attach the IC package 400 to an external substrate (not shown), such as a motherboard. The various substrate stack-ups of the SVLC 402 and/or coreless C-patches 412, 414 may comprise a plurality of dielectric material layers, which may include build-up films and/or solder resist layers, and may be composed of an appropriate dielectric material, including, but not limited to, bismaleimide triazine resin, fire retardant grade 4 material, polyimide material, silica filled epoxy material, glass reinforced epoxy material, as well as laminates or multiple layers thereof, and the like, as well as low-k and ultra low-k dielectrics (dielectric constants less than about 3.6), including, but not limited to, carbon doped dielectrics, fluorine doped dielectrics, porous dielectrics, organic polymeric dielectrics, and the like. The conductive traces, bond pads, and the conductive vias may be made of any appropriate conductive material, including, but not limited to, metals, such as copper, silver, nickel, gold, aluminum, alloys thereof, and the like.

As further shown in FIGs. 13 and 14, a plurality of integrated circuit devices (illustrated as a ICs 432 and 434) may be electrically attached to the coreless C-patches 412, 414 and the EMIB 422. The IC chips 432, 434 (as well as any further IC devices that may be utilized) may be any appropriate device, including, but not limited to, a microprocessor, a chipset, a graphics device, a wireless device, a memory device, an application specific integrated circuit device, combinations thereof, stacks thereof, and the like. The IC chips 432, 434 may be attached to the C-patches 412, 414 through a plurality of device-to-substrate interconnects, such as reflowable solder bumps or balls, in a configuration generally known as a flip-chip or controlled collapse chip connection ("C4") configuration. The device-to-substrate interconnects may extend between bond pads on a first surface of the IC device 432 and corresponding device-to-substrate bond pads, and between the IC device bond pads and corresponding high-density device-to-substrate bond pads to form electrical connections therebetween. The device-to-substrate interconnects may also extend between bond pads on a first surface of the IC device 434 and corresponding device-to-substrate bond pads, and between the IC device bond pads and corresponding high-density device-to-substrate bond pads to form electrical connections therebetween. It is understood that the IC device bond pads of the IC device 432 may be in electrical communication with integrated circuitry (not shown) within the IC device 432, and that the bond pads of the IC device 434 may be in electrical communication with integrated circuitry (not shown) within the IC device 434.

The device-to-substrate interconnects may be any appropriate electrically conductive material, including but not limited to, solder balls, metal bumps or pillars, metal filled epoxies, or a combination thereof. In one embodiment of the present description, the device-to-substrate interconnects may be solder balls formed from tin, lead/tin alloys (for example, 63% tin / 37% lead solder), and high tin content alloys (e.g. 90% or more tin - such as tin/bismuth, eutectic tin/silver, ternary tin/silver/copper, eutectic tin/copper, and similar alloys). In another embodiment of the present description, the device-to-substrate interconnects may be copper bumps or pillars. In a further embodiment of the present description, the device-to-substrate interconnects may be metal bumps or pillars coated with a solder material.

In one embodiment of the present description, an underfill material, such as an epoxy material, may be disposed between the electronic substrate and the IC devices 432 and 434, and surrounding the plurality of device-to-substrate interconnects. As will be understood to those skilled in the art, the underfill material may be dispensed between the first surfaces of the IC devices 432, 434, respectively, and the electronic substrate as a viscous liquid and then hardened with a curing process. The underfill material may also be a molded underfill material. The underfill material may provide structural integrity and may prevent contamination, as will be understood to those skilled in the art. An encapsulation material may be disposed over and between the IC devices 432, 434 for further structural integrity and contamination prevention.

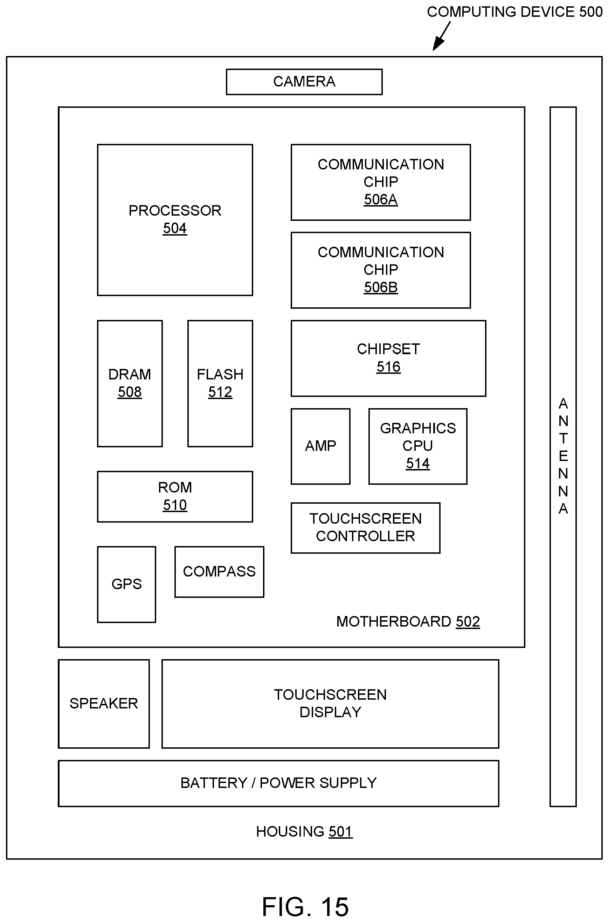

FIG. 15 illustrates an electronic or computing device 500 in accordance with one implementation of the present description. The computing device 500 may include a housing 501 having a board 502 disposed therein. The computing device 500 may include a number of integrated circuit components, including but not limited to a processor 504, at least one communication chip 506A, 506B, volatile memory 508 (e.g., DRAM), non-volatile memory 510 (e.g., ROM), flash memory 512, a graphics processor or CPU 514, a digital signal processor (not shown), a crypto processor (not shown), a chipset 516, an antenna, a display (touchscreen display), a touchscreen controller, a battery/power supply, an audio codec (not shown), a video codec (not shown), a power amplifier (AMP), a global positioning system (GPS) device, a compass, an accelerometer (not shown), a gyroscope (not shown), a speaker, a camera, and a mass storage device (not shown) (such as hard disk drive, compact disk (CD), digital versatile disk (DVD), and so forth). Any of the integrated circuit components may be physically and electrically coupled to the board 502. In some implementations, at least one of the integrated circuit components may be a part of the processor 504.

The communication chip enables wireless communications for the transfer of data to and from the computing device. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device may include a plurality of communication chips. For instance, a first communication chip may be dedicated to shorter range wireless communications such as Wi-Fi and Bluetooth and a second communication chip may be dedicated to longer range wireless communications such as GPS, EDGE, GPRS, CDMA, WiMAX, LTE, Ev-DO, and others.

The term "processor" may refer to any device or portion of a device that processes electronic data from registers and/or memory to transform that electronic data into other electronic data that may be stored in registers and/or memory.

At least one of the integrated circuit components may include an integrated circuit package including a primary interposer comprising a laminate with a metal via through the laminate, two or more secondary interposers attached to a first side of the primary interposer, where respective sidewalls of the two or more secondary interposers define one or more recesses over the primary interposer, and an embedded component within a recess of the one or more recesses defined by the respective sidewalls of the two or more secondary interposers (e.g., and one or more of the other features or aspects of the embodiments described herein).

In various implementations, the computing device may be a laptop, a netbook, a notebook, an ultrabook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, or a digital video recorder. In further implementations, the computing device may be any other electronic device that processes data.

The subject matter of the present description is not necessarily limited to specific applications illustrated in FIGs. 1-15. The subject matter may be applied to other integrated circuit devices and assembly applications, as well as any appropriate electronic application, as will be understood to those skilled in the art.

The follow examples pertain to further embodiments and specifics in the examples may be used anywhere in one or more embodiments, wherein Example 1 is an apparatus comprising a primary interposer including a laminate with a metal via through the laminate, two or more secondary interposers attached to a first side of the primary interposer, wherein respective sidewalls of the two or more secondary interposers define one or more recesses over the primary interposer, and an embedded component within a recess of the one or more recesses defined by the respective sidewalls of the two or more secondary interposers.

In Example 2, the subject matter of Example 1 can optionally include at least a first interposer of the two or more secondary interposers comprising a dielectric material with metallization features embedded in the dielectric material, at least a second interposer of the two or more secondary interposers comprising a dielectric material with metallization features embedded in the dielectric material, and where at least a first sidewall of the dielectric material of the first interposer and at least a first sidewall of the dielectric material of the second interposer define at least a portion of the recess.

In Example 3, the subject matter of Example 2 can optionally include the first interposer comprising a main body of the dielectric material and at least a first protrusion from the main body, the second interposer comprising a main body of the dielectric material and at least a first protrusion from the main body, and where the first protrusion comprising the first sidewall of the first interposer and the second protrusion comprising the first sidewall of the second interposer that define at least the portion of the recess.

In Example 4, the subject matter of Example 3 can optionally include the first interposer further comprising one or more additional protrusions from the main body.

In Example 5, the subject matter of Example 4 can optionally include the main body of the first interposer together with the first protrusion and the one or more additional protrusions from the main body forming one of a C-shape, an E-shape, an F-shape, and H-shape, an I-shape, an S-shape, and a T-shape.

In Example 6, the subject matter of any of Examples 2 to 5 can optionally include the embedded component comprising a bridge attached to the primary interposer and coupled to one or more of the metallization features of the first interposer and the metallization features of the second interposer.

In Example 7, the subject matter of Example 6 can optionally include the primary interposer comprising a stacked via laminate core, the bridge comprising an embedded multi-die interconnect bridge, the first interposer comprising a first coreless patch, and the second interposer comprising a second coreless patch.

In Example 8, the subject matter of any of Examples 2 to 7 can optionally include the metallization features of the first interposer comprising interfaces to couple with an integrated circuit (IC) die through first-level interconnect features, and the apparatus further comprising a first IC chip comprising first terminals coupled to the interfaces of the first interposer, and second terminals coupled to first terminals of the embedded component.

In Example 9, the subject matter of Example 8 can optionally include the metallization features of the second interposer comprising interfaces to couple with an IC die through first-level interconnect features and the apparatus further comprising a second IC chip comprising first terminals coupled to the interfaces of the second interposer, and second terminals coupled to second terminals of the embedded component.

Example 10 is an apparatus comprising an organic interposer, two or more secondary interposers attached to a first side of the organic interposer, wherein respective sidewalls of the two or more secondary interposers define one or more recesses over the organic interposer, an embedded component within a first recess of the one or more recesses defined by the respective sidewalls of the two or more secondary interposers, and one or more integrated circuit (IC) chips attached to at least one of the two or more secondary interposers and the embedded component.

In Example 11, the subject matter of Example 10 can optionally further comprise a signal cable within a second recess of the one or more recesses defined by the respective sidewalls of the two or more secondary interposers, wherein the signal cable is attached to the embedded component.

In Example 12, the subject matter of Example 11 can optionally include the embedded component comprising a photonics integrated circuit (IC) chip attached to the organic interposer, and the signal cable comprising a fiber optic cable.

In Example 13, the subject matter of Example 12 can optionally include the first interposer comprising metallization features and interfaces to couple with an IC die through first-level interconnect features, and wherein a first IC chip of the one or more IC chips comprising first terminals coupled to the interfaces of the first interposer, and second terminals coupled to first terminals of the photonics IC.

In Example 14, the subject matter of Example 13 can optionally include the second interposer comprising metallization features and interfaces to couple with an IC die through first-level interconnect features, and a second IC chip of the one or more IC chips comprising first terminals coupled to the interfaces of the second interposer, and second terminals coupled to second terminals of the embedded component.

In Example 15, the subject matter of any of Examples 10 to 14 can optionally include the a first interposer of the two or more secondary interposers comprising a main body of dielectric material and one or more protrusions that extend from the main body, a second interposer of the two or more secondary interposers comprising a main body of dielectric material and one or more protrusions that extend from the main body, and where at least a first sidewall of the one or more protrusions of the first interposer and at least a first sidewall of the one or more protrusions of the second interposer define at least a portion of the first recess.

Example 16 is an electronic system comprising a board, a power supply to provide power to one or more integrated circuit (IC) chips, and an IC package electrically attached to the board and the power supply, wherein the IC package comprising a primary interposer comprising a laminate with a metal via through the laminate, two or more secondary interposers attached to a first side of the primary interposer, wherein respective sidewalls of the two or more secondary interposers define one or more recesses over the primary interposer, at least a first interposer of the two or more secondary interposers comprising a dielectric material with metallization features embedded in the dielectric material and the metallization features comprising first interfaces to couple with an IC die through first-level interconnect features, at least a second interposer of the two or more secondary interposers comprising a dielectric material with metallization features embedded in the dielectric material, and at least a first sidewall of the dielectric material of the first interposer and at least a first sidewall of the dielectric material of the second interposer define at least a portion of a first recess of the one or more recesses over the primary interposer, an embedded component within the first recess, and a first IC chip comprising first terminals coupled to the interfaces of the first interposer, and second terminals coupled to a first terminals of the embedded component.

In Example 17, the subject matter of Example 16 can optionally include the embedded component comprising a photonics IC chip attached to the primary interposer, and further comprising a fiber optic cable within a second recess of the one or more recesses defined by the respective sidewalls of the two or more secondary interposers and coupled to the photonics IC.

In Example 18, the subject matter of any of Examples 16 to 17 can optionally include the first interposer comprising a first main body of the first dielectric material and at least a first protrusion from the first main body, the second interposer comprising a second main body of the second dielectric material and at least a first protrusion from the second main body, and the first protrusion comprising the first sidewall of the first interposer and the second protrusion comprising the first sidewall of the second interposer that define at least the portion of the first recess.

In Example 19, the subject matter of any of Examples 16 to 18 can optionally include the primary interposer comprising a stacked via laminate core, the embedded component comprising one of a bridge and an IC chip attached to the stacked via laminate core, the first interposer comprising a first coreless patch, and the second interposer comprising a second coreless patch.

In Example 20, the subject matter of Example 19 can optionally include the metallization features of the second interposer comprising first interfaces to couple with an IC die through first-level interconnect features, and further comprising a second IC chip comprising first terminals coupled to the interfaces of the second interposer, and second terminals coupled to second terminals of the embedded component.

Example 21 is an apparatus comprising an organic interposer comprising a laminate with a metal via through the laminate, and two or more patches attached to a first side of the organic interposer and arranged to define one or more recesses over the organic interposer, wherein at least a first patch of the two or patches comprising a first dielectric material with first metallization features embedded in the first dielectric material, at least a second patch of the two or patches comprising a second dielectric material with second metallization features embedded in the second dielectric material, and at least a first sidewall of the first dielectric material of the first patch and at least a first sidewall of the second dielectric material of the second patch define at least a portion of a first recess of the one or more recesses over the organic interposer. Example 22, the subject matter of Example 21, can optionally include further comprising an embedded component within the first recess.

In Example 23, the subject matter of Example 22 can optionally include the embedded component comprising a bridge coupled to the organic interposer.

In Example 24, the subject matter of Example 23 can optionally include the organic interposer comprising a stacked via laminate core, the bridge comprising an embedded multi-die interconnect bridge, the first patch comprising a first coreless patch, and the second patch comprising a second coreless patch.

In Example 25, the subject matter of any of Examples 22 to 24 can optionally include the embedded component comprising an integrated (IC) chip coupled to the organic interposer.

In Example 26, the subject matter of Example 25 can optionally include the organic interposer comprising a stacked via laminate core, the IC chip comprising one of a photonics IC chip and a memory chip, the first patch comprising a first coreless patch, and the second patch comprising a second coreless patch.

In Example 27, the subject matter of any of Examples 22 to 26 can optionally include the first ones of the first metallization features comprising first interfaces to couple with an integrated circuit (IC) die through first-level interconnect features, and the apparatus further comprising a first IC chip comprising first terminals coupled to the first interfaces, and second terminals coupled to first terminals of the embedded component.

In Example 28, the subject matter of Example 27 can optionally include the first ones of the second metallization features comprising second interfaces to couple with an IC die through first-level interconnect features and the apparatus further comprising a second IC chip comprising first terminals coupled to the second interfaces, and second terminals coupled to second terminals of the embedded component.

Example 29 is an apparatus comprising an organic interposer comprising a laminate with a metal via through the laminate, two or more patches attached to a first side of the organic interposer and arranged to define one or more recesses over the organic interposer, wherein at least a first patch of the two or patches comprising a first main body of first dielectric material with first metallization features embedded in the first dielectric material and at least a first protrusion from the first main body, at least a second patch of the two or patches comprising a second main body of second dielectric material with second metallization features embedded in the second dielectric material and at least a first protrusion from the second main body, and at least a first sidewall of the first protrusion of the first patch and at least a first sidewall of the first protrusion of the second patch define at least a portion of a first recess of the one or more recesses over the organic interposer, and an embedded component within the first recess.

In Example 30, the subject matter of Example 29 can optionally include the first patch further comprising one or more additional protrusions from the first main body.

In Example 31, the subject matter of Example 30 can optionally include the first main body together with the first protrusion and the one or more additional protrusions from the main body form one of a C-shape, an E-shape, an F-shape, and H-shape, an I-shape, an S-shape, and a T-shape.

In Example 32, the subject matter of any of Examples 29 to 31 can optionally include the embedded component comprising one of a bridge and an integrated (IC) chip coupled to the organic interposer.

In Example 33, the subject matter of Example 32 can optionally include the organic interposer comprising a stacked via laminate core, the first patch comprising a first coreless patch, and the second patch comprising a second coreless patch.

In Example 34, the subject matter of any of Examples 29 to 33 can optionally include the first ones of the first metallization features comprising first interfaces to couple with an integrated circuit (IC) die through first-level interconnect features, and the apparatus further comprising a first IC chip comprising first terminals coupled to the first interfaces, and second terminals coupled to first terminals of the embedded component.

In Example 35, the subject matter of Example 34 can optionally include the first ones of the second metallization features comprising second interfaces to couple with an IC die through first-level interconnect features and the apparatus further comprising a second IC chip comprising first terminals coupled to the second interfaces, and second terminals coupled to second terminals of the embedded component.

Example 36 is an electronic system comprising a board, a power supply to provide power to one or more integrated circuit (IC) chips, and an IC package electrically attached to the board and the power supply, wherein the IC package comprising an organic interposer comprising a laminate with a metal via through the laminate, and two or more patches attached to a first side of the organic interposer and arranged to define one or more recesses over the organic interposer, wherein at least a first patch of the two or patches comprising a first dielectric material with first metallization features embedded in the first dielectric material and first ones of the first metallization features comprising first interfaces to couple with an IC die through first-level interconnect features, at least a second patch of the two or patches comprising a second dielectric material with second metallization features embedded in the second dielectric material, and at least a first sidewall of the first dielectric material of the first patch and at least a first sidewall of the second dielectric material of the second patch define at least a portion of a first recess of the one or more recesses over the organic interposer, an embedded component within the recess, and a first IC chip comprising first terminals coupled to the first interfaces through first ones of the first-level interconnect features, and second terminals coupled to a first terminals of the embedded component.

In Example 37, the subject matter of Example 36 can optionally include the first patch comprising a first main body of the first dielectric material and at least a first protrusion from the first main body, the second patch comprising a second main body of the second dielectric material and at least a first protrusion from the second main body, and the first protrusion comprising the first sidewall of the first patch and the second protrusion comprising the first sidewall of the second patch that define at least the portion of the first recess.

In Example 38, the subject matter of any of Examples 36 to 37 can optionally include the embedded component comprising one of a bridge and an IC chip coupled to the organic interposer.

In Example 39, the subject matter of Example 38 can optionally include the organic interposer comprising a stacked via laminate core, the first patch comprising a first coreless patch, and the second patch comprising a second coreless patch.

In Example 40, the subject matter of Example 39 can optionally include the first ones of the second metallization features comprising second interfaces to couple with an IC die through first-level interconnect features and the apparatus further comprising a second IC chip comprising first terminals coupled to the second interfaces, and second terminals coupled to second terminals of the embedded component.

In Example 41, the subject matter of any of Examples 36 to 40 can optionally include the embedded component comprising a photonics IC chip attached to the organic interposer, and further comprising a fiber optic cable within a second recess of the one or more recesses defined by the respective sidewalls of the two or more patches and coupled to the photonics IC.

## Claims

1. An apparatus comprising:
a primary interposer (102; 202; 311) comprising a laminate with a metal via through the laminate;
two or more secondary interposers (103, 105, 107; 207, 209; 312, 313) attached to a first side of the primary interposer (102; 202; 311), wherein respective sidewalls (113, 115, 117, 119) of the two or more secondary interposers (103, 105, 107; 207, 209; 312, 313) define two or more recesses (121, 131) over the primary interposer (102; 202; 311);
an embedded component (141, 151; 241, 251; 314) within a first recess (416) of the two or more recesses (121, 131); and
a signal cable (272, 274; 316) within a second recess of the two or more recesses (121, 131) defined by the respective sidewalls (113, 115, 117, 119) of the two or more secondary interposers (103, 105, 107; 207, 209; 312, 313), wherein the signal cable (272, 274; 316) is attached to the embedded component (141, 151; 241, 251; 314).

2. The apparatus of claim 1, wherein:
at least a first interposer of the two or more secondary interposers (103, 105, 107; 207, 209; 312, 313) comprises a dielectric material with metallization features embedded in the dielectric material,
at least a second interposer of the two or more secondary interposers (103, 105, 107; 207, 209; 312, 313) comprises a dielectric material with metallization features embedded in the dielectric material, and
at least a first sidewall of the dielectric material of the first interposer and at least a first sidewall of the dielectric material of the second interposer define at least a portion of the recess (121, 131).

3. The apparatus of claim 2, wherein:
the first interposer comprises a main body of the dielectric material and at least a first protrusion from the main body,
the second interposer comprises a main body of the dielectric material and at least a first protrusion from the main body, and
the first protrusion comprises the first sidewall of the first interposer and the second protrusion comprises the first sidewall of the second interposer that define at least the portion of the recess (121, 131).

4. The apparatus of claim 3, wherein the first interposer further comprises one or more additional protrusions from the main body.

5. The apparatus of claim 4, wherein the main body of the first interposer together with the first protrusion and the one or more additional protrusions from the main body form one of a C-shape, an E-shape, an F-shape, and H-shape, an I-shape, an S-shape, and a T-shape.

6. The apparatus of any of claims 2 to 5, wherein the embedded component (141, 151; 241, 251; 314) comprises a bridge attached to the primary interposer (102; 202; 311) and coupled to one or more of the metallization features of the first interposer and the metallization features of the second interposer.

7. An apparatus according to claim 1, comprising:
an organic interposer;
two or more secondary interposers (103, 105, 107; 207, 209; 312, 313) attached to a first side of the organic interposer, wherein respective sidewalls (113, 115, 117, 119) of the two or more secondary interposers (103, 105, 107; 207, 209; 312, 313) define two or more recesses (121, 131) over the organic interposer;
an embedded component (141, 151; 241, 251; 314) within a first recess (416) of the two or more recesses (121, 131) defined by the respective sidewalls (113, 115, 117, 119) of the two or more secondary interposers (103, 105, 107; 207, 209; 312, 313);
a signal cable (272, 274; 316) within a second recess of the two or more recesses (121, 131) defined by the respective sidewalls (113, 115, 117, 119) of the two or more secondary interposers (103, 105, 107; 207, 209; 312, 313), wherein the signal cable (272, 274; 316) is attached to the embedded component (141, 151; 241, 251; 314); and
one or more integrated circuit, IC (432, 434), chips attached to at least one of the two or more secondary interposers (103, 105, 107; 207, 209; 312, 313) and the embedded component (141, 151; 241, 251; 314).

8. The apparatus of claim 7, wherein the embedded component (141, 151; 241, 251; 314) comprises a photonics integrated circuit, IC (432, 434), chip attached to the organic interposer, and wherein the signal cable (272, 274; 316) comprises a fiber optic cable.

9. The apparatus of claim 8, wherein the first interposer comprises metallization features and interfaces to couple with an IC (432, 434) die through first-level interconnect features, and wherein a first IC chip (161) of the one or more IC chips (161, 163, 171; 315, 317; 432, 434) comprises first terminals coupled to the interfaces of the first interposer, and second terminals coupled to first terminals of the photonics IC.

10. The apparatus of claim 9, wherein the second interposer comprises metallization features and interfaces to couple with an IC (432, 434) die through first-level interconnect features, and wherein a second IC chip (163) of the one or more IC chips (161, 163, 171; 315, 317; 432, 434) comprises first terminals coupled to the interfaces of the second interposer, and second terminals coupled to second terminals of the embedded component (141, 151; 241, 251; 314).

11. An electronic system (300) comprising:
a board (301; 502);
a power supply (302) to provide power to one or more integrated circuit, IC (432, 434), chips; and
an IC package (100; 200, 260; 310; 400) electrically attached to the board (301; 502) and the power supply (302), wherein the IC package (100; 200, 260; 310; 400) comprises:
a primary interposer (102; 202; 311) comprising a laminate with a metal via through the laminate,
two or more secondary interposers (103, 105, 107; 207, 209; 312, 313) attached to a first side of the primary interposer (102; 202; 311), wherein: respective sidewalls (113, 115, 117, 119) of the two or more secondary interposers (103, 105, 107; 207, 209; 312, 313) define two or more recesses (121, 131) over the primary interposer (102; 202; 311), at least a first interposer of the two or more secondary interposers (103, 105, 107; 207, 209; 312, 313) comprises a dielectric material with metallization features embedded in the dielectric material and the metallization features comprise first interfaces to couple with an IC die through first-level interconnect features, at least a second interposer of the two or more secondary interposers (103, 105, 107; 207, 209; 312, 313) comprises a dielectric material with metallization features embedded in the dielectric material, and at least a first sidewall of the dielectric material of the first interposer and at least a first sidewall of the dielectric material of the second interposer define at least a portion of a first recess (416) of the two or more recesses (121, 131) over the primary interposer (102; 202; 311),
an embedded component (141, 151; 241, 251; 314) within the first recess (416),
a signal cable (272, 274; 316) within a second recess of the two or more recesses (121, 131) defined by the respective sidewalls (113, 115, 117, 119) of the two or more secondary interposers (103, 105, 107; 207, 209; 312, 313), wherein the signal cable (272, 274; 316) is attached to the embedded component (141, 151; 241, 251; 314), and
a first IC chip (161) comprising first terminals coupled to the interfaces of the first interposer, and second terminals coupled to a first terminals of the embedded component (141, 151; 241, 251; 314).

12. The system (300) of claim 11, wherein the embedded component (141, 151; 241, 251; 314) comprises a photonics IC chip attached to the primary interposer (102; 202; 311), and further comprising:
a fiber optic cable within a second recess of the two or more recesses (121, 131) defined by the respective sidewalls (113, 115, 117, 119) of the two or more secondary interposers (103, 105, 107; 207, 209; 312, 313) and coupled to the photonics IC.

13. The system (300) of any of claims 11 to 12, wherein:
the first interposer comprises a first main body of the first dielectric material and at least a first protrusion from the first main body,
the second interposer comprises a second main body of the second dielectric material and at least a first protrusion from the second main body, and
the first protrusion comprises the first sidewall of the first interposer and the second protrusion comprises the first sidewall of the second interposer that define at least the portion of the first recess (416).

14. The system (300) of any of claims 11 to 13, wherein:
the primary interposer (102; 202; 311) comprises a stacked via laminate core,
the embedded component (141, 151; 241, 251; 314) comprises one of a bridge and an IC chip (161, 163, 171; 315, 317; 432, 434) attached to the stacked via laminate core,
the first interposer comprises a first coreless patch, and
the second interposer comprises a second coreless patch.

15. The system (300) of claim 14, wherein the metallization features of the second interposer comprise first interfaces to couple with an IC (432, 434) die through first-level interconnect features, and further comprising:
a second IC chip (163) comprising first terminals coupled to the interfaces of the second interposer, and second terminals coupled to second terminals of the embedded component (141, 151; 241, 251; 314).

## Patentansprüche

1. Einrichtung, die Folgendes umfasst:
einen primären Interposer (102; 202; 311), der ein Laminat mit einem Metall-Via durch das Laminat umfasst;
zwei oder mehr sekundäre Interposer (103, 105, 107; 207, 209; 312, 313), die an einer ersten Seite des primären Interposers (102; 202; 311) angebracht sind, wobei jeweilige Seitenwände (113, 115, 117, 119) der zwei oder mehr sekundären Interposer (103, 105, 107; 207, 209; 312, 313) zwei oder mehr Vertiefungen (121, 131) über dem primären Interposer (102; 202; 311) definieren;
eine eingebettete Komponente (141, 151; 241, 251; 314) innerhalb einer ersten Vertiefung (416) der zwei oder mehr Vertiefungen (121, 131); und
ein Signalkabel (272, 274; 316) innerhalb einer zweiten Vertiefung der zwei oder mehr Vertiefungen (121, 131), die durch die jeweiligen Seitenwände (113, 115, 117, 119) der zwei oder mehr sekundären Interposer (103, 105, 107; 207, 209; 312, 313) definiert sind, wobei das Signalkabel (272, 274; 316) an der eingebetteten Komponente (141, 151; 241, 251; 314) angebracht ist.

2. Einrichtung nach Anspruch 1, wobei:
mindestens ein erster Interposer der zwei oder mehr Interposer (103, 105, 107; 207, 209; 312, 313) ein dielektrisches Material mit Metallisierungsmerkmalen umfasst, die in das dielektrische Material eingebettet sind,
mindestens ein zweiter Interposer der zwei oder mehr sekundären Interposer (103, 105, 107; 207, 209; 312, 313) ein dielektrisches Material mit Metallisierungsmerkmalen umfasst, die in das dielektrische Material eingebettet sind, und
mindestens eine erste Seitenwand des dielektrischen Materials des ersten Interposers und mindestens eine erste Seitenwand des dielektrischen Materials des zweiten Interposers mindestens einen Teil der Vertiefung (121, 131) definieren.

3. Einrichtung nach Anspruch 2, wobei:
der erste Interposer einen Hauptkörper des dielektrischen Materials und mindestens einen ersten Vorsprung von dem Hauptkörper umfasst,
der zweite Interposer einen Hauptkörper des dielektrischen Materials und mindestens einen ersten Vorsprung von dem Hauptkörper umfasst, und
der erste Vorsprung die erste Seitenwand des ersten Interposers umfasst und der zweite Vorsprung die erste Seitenwand des zweiten Interposers umfasst, die mindestens den Teil der Vertiefung (121, 131) definieren.

4. Einrichtung nach Anspruch 3, wobei der erste Interposer ferner einen oder mehrere zusätzliche Vorsprünge von dem Hauptkörper umfasst.

5. Einrichtung nach Anspruch 4, wobei der Hauptkörper des ersten Interposers zusammen mit dem ersten Vorsprung und dem einen oder den mehreren zusätzlichen Vorsprüngen von dem Hauptkörper eine einer C-Form, einer E-Form, einer F-Form und einer H-Form, einer I-Form, einer S-Form und einer T-Form bilden.

6. Einrichtung nach einem der Ansprüche 2 bis 5, wobei die eingebettete Komponente (141, 151; 241, 251; 314) eine Brücke umfasst, die an dem primären Interposer (102; 202; 311) angebracht und mit einem oder mehreren der Metallisierungsmerkmale des ersten Interposers und der Metallisierungsmerkmale des zweiten Interposers gekoppelt ist.

7. Einrichtung nach Anspruch 1, die Folgendes umfasst:
einen organischen Interposer;
zwei oder mehr sekundäre Interposer (103, 105, 107; 207, 209; 312, 313), die an einer ersten Seite des organischen Interposers angebracht sind, wobei jeweilige Seitenwände (113, 115, 117, 119) der zwei oder mehr sekundären Interposer (103, 105, 107; 207, 209; 312, 313) zwei oder mehr Vertiefungen (121, 131) über dem organischen Interposer definieren;
eine eingebettete Komponente (141, 151; 241, 251; 314) innerhalb einer ersten Vertiefung (416) der zwei oder mehr Vertiefungen (121, 131), die durch die jeweiligen Seitenwände (113, 115, 117, 119) der zwei oder mehr sekundären Interposer (103, 105, 107; 207, 209; 312, 313) definiert sind;
ein Signalkabel (272, 274; 316) innerhalb einer zweiten Vertiefung der zwei oder mehr Vertiefungen (121, 131), die durch die jeweiligen Seitenwände (113, 115, 117, 119) der zwei oder mehr sekundären Interposer (103, 105, 107; 207, 209; 312, 313) definiert sind, wobei das Signalkabel (272, 274; 316) an der eingebetteten Komponente (141, 151; 241, 251; 314) angebracht ist; und
einen oder mehrere integrierte Schaltungs-, IC- (432, 434), Chips, die an mindestens einem der zwei oder mehr sekundären Interposer (103, 105, 107; 207, 209; 312, 313) und der eingebetteten Komponente (141, 151; 241, 251; 314) angebracht sind.

8. Einrichtung nach Anspruch 7, wobei die eingebettete Komponente (141, 151; 241, 251; 314) einen integrierten Photonikschaltungs-, IC (432, 434), Chip, umfasst, der an dem organischen Interposer angebracht ist, und wobei das Signalkabel (272, 274; 316) ein faseroptisches Kabel umfasst.

9. Einrichtung nach Anspruch 8, wobei der erste Interposer Metallisierungsmerkmale und Schnittstellen zum Koppeln mit einem IC- (432, 434) Die durch Zwischenverbindungsmerkmale erster Ebene umfasst, und wobei ein erster IC-Chip (161) des einen oder der mehreren IC-Chips (161, 163, 171; 315, 317; 432, 434) erste Anschlüsse, die mit den Schnittstellen des ersten Interposers gekoppelt sind, und zweite Anschlüsse, die mit ersten Anschlüssen der Photonik-IC gekoppelt sind, umfasst.

10. Einrichtung nach Anspruch 9, wobei der zweite Interposer Metallisierungsmerkmale und Schnittstellen zum Koppeln mit einem IC- (432, 434) Die durch Zwischenverbindungsmerkmale erster Ebene umfasst, und wobei ein zweiter IC-Chip (163) des einen oder der mehreren IC-Chips (161, 163, 171; 315, 317; 432, 434) erste Anschlüsse, die mit den Schnittstellen des zweiten Interposers gekoppelt sind, und zweite Anschlüsse, die mit zweiten Anschlüssen der eingebetteten Komponente (141, 151; 241, 251; 314) gekoppelt sind, umfasst.

11. Elektronisches System (300), das Folgendes umfasst:
eine Platine (301; 502);
eine Stromversorgung (302), um einen oder mehrere integrierte Schaltungs, IC- (432, 434), Chips mit Leistung zu versorgen; und
ein IC-Gehäuse (100; 200, 260; 310; 400), das elektrisch an der Platine (301; 502) und der Stromversorgung (302) angebracht ist, wobei das IC-Gehäuse (100; 200, 260; 310; 400) Folgendes umfasst:
einen primären Interposer (102; 202; 311), der ein Laminat mit einem Metall-Via durch das Laminat umfasst,
zwei oder mehr sekundäre Interposer (103, 105, 107; 207, 209; 312, 313), die an einer ersten Seite des primären Interposers (102; 202; 311) angebracht sind, wobei:
jeweilige Seitenwände (113, 115, 117, 119) der zwei oder mehr sekundären Interposer (103, 105, 107; 207, 209; 312, 313) zwei oder mehr Vertiefungen (121, 131) über dem primären Interposer (102; 202; 311) definieren, wobei mindestens ein erster Interposer der zwei oder mehr sekundären Interposer (103, 105, 107; 207, 209; 312, 313) ein dielektrisches Material mit Metallisierungsmerkmalen umfasst, die in das dielektrische Material eingebettet sind, und die Metallisierungsmerkmale erste Schnittstellen zum Koppeln mit einem IC-Die durch Zwischenverbindungsmerkmale erster Ebene umfassen, wobei mindestens ein zweiter Interposer der zwei oder mehr sekundären Interposer (103, 105, 107; 207, 209; 312, 313) ein dielektrisches Material mit Metallisierungsmerkmalen umfasst, die in das dielektrische Material eingebettet sind, und wobei mindestens eine erste Seitenwand des dielektrischen Materials des ersten Interposers und mindestens eine erste Seitenwand des dielektrischen Materials des zweiten Interposers mindestens einen Teil einer ersten Vertiefung (416) der zwei oder mehr Vertiefungen (121, 131) über dem primären Interposer (102; 202; 311) definieren,
eine eingebettete Komponente (141, 151; 241, 251; 314) innerhalb der ersten Vertiefung (416),
ein Signalkabel (272, 274; 316) innerhalb einer zweiten Vertiefung der zwei oder mehr Vertiefungen (121, 131), die durch die jeweiligen Seitenwände (113, 115, 117, 119) der zwei oder mehr sekundären Interposer (103, 105, 107; 207, 209; 312, 313) definiert sind, wobei das Signalkabel (272, 274; 316) an der eingebetteten Komponente (141, 151; 241, 251; 314) angebracht ist, und
einen ersten IC-Chip (161), der erste Anschlüsse, die mit den Schnittstellen des ersten Interposers gekoppelt sind, und zweite Anschlüsse, die mit ersten Anschlüssen der eingebetteten Komponente (141, 151; 241, 251; 314) gekoppelt sind, umfasst.

12. System (300) nach Anspruch 11, wobei die eingebettete Komponente (141, 151; 241, 251; 314) einen Photonik-IC-Chip umfasst, der an dem primären Interposer (102; 202; 311) angebracht ist, und ferner umfassend:
ein faseroptisches Kabel innerhalb einer zweiten Vertiefung der zwei oder mehr Vertiefungen (121, 131), die durch die jeweiligen Seitenwände (113, 115, 117, 119) der zwei oder mehr sekundären Interposer (103, 105, 107; 207, 209; 312, 313) definiert und mit der Photonik-IC gekoppelt sind.

13. System (300) nach einem der Ansprüche 11 bis 12, wobei:
der erste Interposer einen ersten Hauptkörper des ersten dielektrischen Materials und mindestens einen ersten Vorsprung von dem ersten Hauptkörper umfasst,
der zweite Interposer einen zweiten Hauptkörper des zweiten dielektrischen Materials und mindestens einen ersten Vorsprung von dem zweiten Hauptkörper umfasst, und
der erste Vorsprung die erste Seitenwand des ersten Interposers umfasst und der zweite Vorsprung die erste Seitenwand des zweiten Interposers umfasst, die mindestens den Teil der ersten Vertiefung (416) definieren.

14. System (300) nach einem der Ansprüche 11 bis 13, wobei:
der primäre Interposer (102; 202; 311) einen gestapelten Via-Laminatkern umfasst,
die eingebettete Komponente (141, 151; 241, 251; 314) eines einer Brücke und eines IC-Chips (161, 163, 171; 315, 317; 432, 434) umfasst, die bzw. der an dem gestapelten Via-Laminatkern angebracht ist,
der erste Interposer ein erstes kernloses Patch umfasst, und
der zweite Interposer ein zweites kernloses Patch umfasst.

15. System (300) nach Anspruch 14, wobei die Metallisierungsmerkmale des zweiten Interposers erste Schnittstellen zum Koppeln mit einem IC- (432, 434) Die durch Zwischenverbindungsmerkmale erster Ebene umfassen, und ferner umfassend:
einen zweiten IC-Chip (163), der erste Anschlüsse, die mit den Schnittstellen des zweiten Interposers gekoppelt sind, und zweite Anschlüsse, die mit zweiten Anschlüssen der eingebetteten Komponente (141, 151; 241, 251; 314) gekoppelt sind, umfasst.

## Revendications

1. Appareil comprenant :
un interposeur primaire (102 ; 202 ; 311) comportant un stratifié avec un via métallique à travers le stratifié ;
au moins deux interposeurs secondaires (103, 105, 107 ; 207, 209 ; 312, 313) fixés à un premier côté de l'interposeur primaire (102 ; 202 ; 311), des parois latérales (113, 115, 117, 119) respectives des au moins deux interposeurs secondaires (103, 105, 107 ; 207, 209 ; 312, 313) définissant au moins deux évidements (121, 131) au-dessus de l'interposeur primaire (102 ; 202 ; 311) ;
un composant incorporé (141, 151 ; 241, 251 ; 314) à l'intérieur d'un premier évidement (416) parmi les au moins deux évidements (121, 131) ; et
un câble de signal (272, 274 ; 316) à l'intérieur d'un deuxième évidement parmi les au moins deux évidements (121, 131) définis par les parois latérales (113, 115, 117, 119) respectives des au moins deux interposeurs secondaires (103, 105, 107 ; 207, 209 ; 312, 313), le câble de signal (272, 274 ; 316) étant fixé au composant incorporé (141, 151 ; 241, 251 ; 314).

2. Appareil de la revendication 1, dans lequel :
au moins un premier interposeur parmi les au moins deux interposeurs secondaires (103, 105, 107 ; 207, 209 ; 312, 313) comprend un matériau diélectrique avec des éléments de métallisation incorporés dans le matériau diélectrique,
au moins un deuxième interposeur parmi les au moins deux interposeurs secondaires (103, 105, 107 ; 207, 209 ; 312, 313) comprend un matériau diélectrique avec des éléments de métallisation incorporés dans le matériau diélectrique, et
au moins une première paroi latérale du matériau diélectrique du premier interposeur et au moins une première paroi latérale du matériau diélectrique du deuxième interposeur définissent au moins une partie de l'évidement (121, 131).

3. Appareil de la revendication 2, dans lequel :
le premier interposeur comprend un corps principal du matériau diélectrique et au moins une première saillie à partir du corps principal,
le deuxième interposeur comprend un corps principal du matériau diélectrique et au moins une première saillie à partir du corps principal, et
la première saillie comprend la première paroi latérale du premier interposeur et la deuxième saillie comprend la première paroi latérale du deuxième interposeur qui définissent au moins la partie de l'évidement (121, 131).

4. Appareil selon la revendication 3, dans lequel le premier interposeur comprend en outre une ou plusieurs saillies supplémentaires à partir du corps principal.

5. Appareil selon la revendication 4, dans lequel le corps principal du premier interposeur forme, conjointement avec la première saillie et la ou les saillies supplémentaires à partir du corps principal, l'une parmi une forme en C, une forme en E, une forme en F, une forme en H, une forme en I, une forme en S, et une forme en T.

6. Appareil selon l'une quelconque des revendications 2 à 5, dans lequel le composant incorporé (141, 151 ; 241, 251 ; 314) comprend un pont fixé à l'interposeur primaire (102 ; 202 ; 311) et couplé à un ou plusieurs des éléments de métallisation du premier interposeur et des éléments de métallisation du deuxième interposeur.

7. Appareil selon la revendication 1, comprenant :
un interposeur organique ;
au moins deux interposeurs secondaires (103, 105, 107 ; 207, 209 ; 312, 313) fixés à un premier côté de l'interposeur organique, des parois latérales (113, 115, 117, 119) respectives des au moins deux interposeurs secondaires (103, 105, 107 ; 207, 209 ; 312, 313) définissant au moins deux évidements (121, 131) au-dessus de l'interposeur organique ;
un composant incorporé (141, 151 ; 241, 251 ; 314) à l'intérieur d'un premier évidement (416) parmi les au moins deux évidements (121, 131) définis par les parois latérales (113, 115, 117, 119) respectives des au moins deux interposeurs secondaires (103, 105, 107 ; 207, 209 ; 312, 313) ;
un câble de signal (272, 274 ; 316) à l'intérieur d'un deuxième évidement parmi les au moins deux évidements (121, 131) définis par les parois latérales (113, 115, 117, 119) respectives des au moins deux interposeurs secondaires (103, 105, 107 ; 207, 209 ; 312, 313), le câble de signal (272, 274 ; 316) étant fixé au composant incorporé (141, 151 ; 241, 251 ; 314) ; et
une ou plusieurs puces de circuit intégré, CI, (432, 434), fixées à au moins l'un des au moins deux interposeurs secondaires (103, 105, 107 ; 207, 209 ; 312, 313) et au composant incorporé (141, 151 ; 241, 251 ; 314).

8. Appareil selon la revendication 7, dans lequel le composant incorporé (141, 151 ; 241, 251 ; 314) comprend une puce de circuit intégré, CI, photonique (432, 434), fixée à l'interposeur organique, et dans lequel le câble de signal (272, 274 ; 316) comprend un câble à fibres optiques.

9. Appareil selon la revendication 8, dans lequel le premier interposeur comprend des éléments de métallisation et des interfaces pour se coupler à une puce nue de CI (432, 434) par l'intermédiaire d'éléments d'interconnexion de premier niveau, et dans lequel une première puce de CI (161) parmi la ou les puces de CI (161, 163, 171 ; 315, 317 ; 432, 434) comporte des premières bornes couplées aux interfaces du premier interposeur, et des deuxièmes bornes couplées à des premières bornes du CI photonique.

10. Appareil selon la revendication 9, dans lequel le deuxième interposeur comprend des éléments de métallisation et des interfaces pour se coupler à une puce nue de CI (432, 434) par l'intermédiaire d'éléments d'interconnexion de premier niveau, et dans lequel une deuxième puce de CI (163) parmi la ou les puces de CI (161, 163, 171 ; 315, 317 ; 432, 434) comprend des premières bornes couplées aux interfaces du deuxième interposeur, et des deuxièmes bornes couplées aux deuxièmes bornes du composant incorporé (141, 151 ; 241, 251 ; 314).

11. Système électronique (300) comprenant :
une carte (301 ; 502) ; et
une alimentation électrique (302) destinée à alimenter électriquement une ou plusieurs puces de circuit intégré, CI, (432, 434) ; et
un boîtier de CI (100 ; 200, 260 ; 310 ; 400) fixé électriquement à la carte (301 ; 502) et à l'alimentation électrique (302), le boîtier de CI (100 ; 200, 260 ; 310 ; 400) comprenant :
un interposeur primaire (102 ; 202 ; 311) comportant un stratifié avec un via métallique à travers le stratifié ;
au moins deux interposeurs secondaires (103, 105, 107 ; 207, 209 ; 312, 313) fixés à un premier côté de l'interposeur primaire (102 ; 202 ; 311), des parois latérales (113, 115, 117, 119) respectives des au moins deux interposeurs secondaires (103, 105, 107 ; 207, 209 ; 312, 313) définissant au moins deux évidements (121, 131) sur l'interposeur primaire (102 ; 202 ; 311), au moins un premier interposeur parmi les au moins deux interposeurs secondaires (103, 105, 107 ; 207, 209 ; 312, 313) comprenant un matériau diélectrique avec des éléments de métallisation incorporés dans le matériau diélectrique et les éléments de métallisation comprenant des premières interfaces pour se coupler à une puce nue de CI par l'intermédiaire d'éléments d'interconnexion de premier niveau, au moins un deuxième interposeur parmi les au moins deux interposeurs secondaires (103, 105, 107 ; 207, 209 ; 312, 313) comprenant un matériau diélectrique avec des éléments de métallisation incorporés dans le matériau diélectrique, et au moins une première paroi latérale du matériau diélectrique du premier interposeur et au moins une première paroi latérale du matériau diélectrique du deuxième interposeur définissant au moins une partie d'un premier évidement (416) parmi les au moins deux évidements (121, 131) au-dessus de l'interposeur primaire (102 ; 202 ; 311),
un composant incorporé (141, 151 ; 241, 251 ; 314) à l'intérieur du premier évidement (416),
un câble de signal (272, 274 ; 316) à l'intérieur d'un deuxième évidement parmi les au moins deux évidements (121, 131) définis par les parois latérales (113, 115, 117, 119) respectives des au moins deux interposeurs secondaires (103, 105, 107 ; 207, 209 ; 312, 313), le câble de signal (272, 274 ; 316) étant fixé au composant incorporé (141, 151 ; 241, 251 ; 314), et
une première puce de CI (161) comprenant des premières bornes couplées aux interfaces du premier interposeur, et des deuxièmes bornes couplées à des premières bornes du composant incorporé (141, 151 ; 241, 251 ; 314).

12. Système (300) selon la revendication 11, dans lequel le composant incorporé (141, 151 ; 241, 251 ; 314) comprend une puce de CI photonique fixée à l'interposeur primaire (102 ; 202 ; 311), et comprenant en outre :
un câble à fibres optiques à l'intérieur d'un deuxième évidement parmi les au moins deux évidements (121, 131) définis par les parois latérales (113, 115, 117, 119) respectives des au moins deux interposeurs secondaires (103, 105, 107 ; 207, 209 ; 312, 313) et couplé au CI photonique.

13. Système (300) selon l'une quelconque des revendications 11 à 12, dans lequel :
le premier interposeur comprend un premier corps principal du premier matériau diélectrique et au moins une première saillie à partir du premier corps principal,
le deuxième interposeur comprend un deuxième corps principal du deuxième matériau diélectrique et au moins une première saillie à partir du deuxième corps principal, et
la première saillie comprend la première paroi latérale du premier interposeur et la deuxième saillie comprend la première paroi latérale du deuxième interposeur qui définissent au moins la partie du premier évidement (416).

14. Système (300) selon l'une quelconque des revendications 11 à 13, dans lequel :
l'interposeur primaire (102 ; 202 ; 311) comporte un noyau en stratifié à vias superposés,
le composant incorporé (141, 151 ; 241, 251 ; 314) comprend soit un pont, soit une puce de CI (161, 163, 171 ; 315, 317 ; 432, 434) fixé ou fixée au noyau en stratifié à vias superposés,
le premier interposeur comprend une première pastille sans noyau, et
le deuxième interposeur comprend une deuxième pastille sans noyau.

15. Système (300) selon la revendication 14, dans lequel les éléments de métallisation du deuxième interposeur comprennent des premières interfaces pour se coupler à une puce nue de CI (432, 434) par l'intermédiaire d'éléments d'interconnexion de premier niveau, et comprenant en outre :
une deuxième puce de CI (163) comprenant des premières bornes couplées aux interfaces du deuxième interposeur, et des deuxièmes bornes couplées à des deuxièmes bornes du composant incorporé (141, 151 ; 241, 251 ; 314).
